# EUROPÄISCHE PATENTSCHRIFT

(11) **EP 3 221 899 B1**
(45) Veröffentlichungstag und Bekanntmachung des Hinweises auf die Patenterteilung: **12.07.2023**
(21) Anmeldenummer: 15797653.1
(22) Anmeldetag: 18.11.2015
(51) Int. Cl.: H01L 31/032, H01L 31/18, H01L 21/02, H01L 31/062, H01L 31/0392

(54) **SCHICHTAUFBAU FÜR EINE DÜNNSCHICHTSOLARZELLE UND HERSTELLUNGSVERFAHREN**
LAYER STRUCTURE FOR A THIN-FILM SOLAR CELL AND PRODUCTION METHOD
STRUCTURE DE COUCHES POUR CELLULE SOLAIRE À COUCHE MINCE ET PROCÉDÉ DE FABRICATION

(30) Priorität: 18.11.2014 DE 102014223485
(43) Veröffentlichungstag der Anmeldung: 27.09.2017
(73) Patentinhaber: Zentrum für Sonnenenergie- und Wasserstoff-Forschung Baden-Württemberg, 70563 Stuttgart (DE)
(72) Erfinder: WÜRZ, Roland, 71394 Kernen i.R. (DE); POWALLA, Michael, 76359 Marxzell (DE); JACKSON, Philip, 72074 Tübingen (DE); HARISKOS, Dimitrios, 70806 Kornwestheim (DE)
(74) Vertreter: Patentanwälte Ruff, Wilhelm, Beier, Dauster & Partner mbB
(86) Internationale Anmeldenummer: PCT/EP2015/076996
(87) Internationale Veröffentlichungsnummer: WO 2016/079198

(56) Entgegenhaltungen:
- EP-A1- 0 460 287
- WO-A1-2013/068702
- US-A1- 2011 192 454
- US-A1- 2012 024 366
- US-A1- 2014 124 011
- US-A1- 2014 338 741

## Beschreibung

Die Erfindung bezieht sich auf einen Schichtaufbau für eine Dünnschichtsolarzelle mit einer photovoltaischen Absorberschicht, die wenigstens in einem Bereich, der an eine frontkontaktseitige Oberfläche der photovoltaischen Absorberschicht angrenzt, mit mindestens einem Alkalimetall dotiert ist. Des Weiteren bezieht sich die Erfindung auf ein Verfahren zur Herstellung eines solchen Schichtaufbaus.

Ein gattungsgemäßer Schichtaufbau und zugehöriges Herstellungsverfahren sind aus der WO 2014/097112 A1 bekannt. Herkömmlicherweise ist der Schichtaufbau mit der photovoltaischen Absorberschicht in die Dünnschichtsolarzelle integriert. Untersuchungen haben gezeigt, dass eine Alkalimetalldotierung die für die photoelektrische Aktivität relevanten Eigenschaften der Absorberschicht, die typischerweise ein Verbindungshalbleitermaterial umfasst, günstig beeinflussen und zu einer merklichen Wirkungsgradverbesserung der Dünnschichtsolarzelle führen kann. Allerdings bringt die Alkalimetalldotierung bestimmte Schwierigkeiten mit sich. Insbesondere können der Füllfaktor und damit auch der Wirkungsgrad mancher Dünnschichtsolarzellen dieser Art gegenüber anderen, baugleichen Dünnschichtsolarzellen merklich verringert sein.

In der Offenlegungsschrift US 2011/0192454 A1 wird für einen weiteren gattungsgemä-ßen Schichtaufbau die Verwendung einer transparenten Barrierenschicht zwischen der Absorberschicht und einer Frontkontaktstruktur vorgeschlagen, um den Schichtaufbau beständiger gegenüber Feuchtigkeit, Sauerstoffdegradation und Migration von Na, Li oder einem Lanthanoid aus der Absorberschicht zu machen.

Die Offenlegungsschrift US 2014/0124011 A1 schlägt nach dem Aufbringen einer Barrierenschicht aus CdS, Cd₁₋ₓZnₓS mit 0<x≤ 1, In₂S₃, Zn(O,S) oder Zn(O,S,OH) auf eine Chalkogenid-Absorberschicht anstelle eines als nachteilig angesehenen oxidativen Temperprozesses die Durchführung eines Sulfurisierungs- oder Selenisierungsprozesses bei einer ausreichend niedrigen Temperatur, durch die ein pn-Übergang zwischen der Barrierenschicht und der Absorberschicht nicht geschädigt wird, vor, durch den Korngrenzen in der Absorberschicht sowie Grenzflächen zwischen der Barrierenschicht und der Absorberschicht und zwischen der Absorberschicht und einer darunterliegenden Substratschicht passiviert werden sollen.

Die Offenlegungsschrift DE 44 40 878 A1 offenbart eine Verbindungshalbleiter-Dünnschichtsolarzelle und ein zugehöriges Herstellungsverfahren, bei dem auf einem Glasträger eine Molybdän-Rückkontaktschicht und auf dieser eine natrium- und sauerstoffhaltige Vorläuferschicht aufgebracht werden, wobei statt Natrium auch Lithium oder Kalium verwendbar ist. Dann wird auf der Vorläuferschicht ein Absorberschichtmaterial zur Bildung einer entsprechenden photovoltaischen Absorberschicht derart abgeschieden, dass das Material der Vorläuferschicht während des Aufwachsens der Absorberschicht in diese hineindiffundiert und dort eingebaut wird, vorzugsweise vollständig. Auf die Absorberschicht werden dann nacheinander eine Pufferschicht und eine lichttransparente, leitfähige, frontseitige Fensterschicht als Frontkontaktschicht aufgebracht.

Die Offenlegungsschrift WO 2013/068702 A1 schlägt für eine gattungsgemäße Verbindungshalbleiter-Dünnschichtsolarzelle das Aufbringen einer Passivierungsschicht aus intrinsischem ZnO oder intrinsischem ZnMgO auf eine auf der Absorberschicht gebildete Barrierenschicht aus CdS, InₓS_{y}, Zn(O,S) oder ZnMgO oder optional ohne Bildung der Barrierenschicht direkt auf die Absorberschicht vor.

Weitere herkömmliche Dünnschichtsolarzellen-Schichtaufbauten sind in den Offenlegungsschriften EP 0 460 287 A1 und US 2012/0024366 A1 angegeben.

Der Erfindung liegt als technisches Problem die Bereitstellung eines Schichtaufbaus mit verbesserten chemischen und physikalischen Eigenschaften zur Steigerung des Wirkungsgrads einer Dünnschichtsolarzelle mit einem solchen Schichtaufbau sowie ein Verfahren zur Herstellung eines solchen Schichtaufbaus zugrunde.

Die Erfindung löst dieses Problem durch die Bereitstellung eines Schichtaufbaus mit den Merkmalen des Anspruchs 1 und eines Verfahrens zur Herstellung des Schichtaufbaus mit den Merkmalen des Anspruchs 7.

Der erfindungsgemäße Schichtaufbau weist eine oxidische Passivierungsschicht an der frontkontaktseitigen Oberfläche der photovoltaischen Absorberschicht auf, die dazu ausgebildet ist, die photovoltaische Absorberschicht vor Korrosion zu schützen.

Die oxidische Passivierungsschicht umfasst oder besteht aus einem Material mit einer Sauerstoff-Verbindung. Die oxidische Passivierungsschicht ist an der Oberfläche in die photovoltaische Absorberschicht eingebaut, wobei die photovoltaische Absorberschicht an der Oberfläche umgewandelt ist. Die oxidische Passivierungsschicht bedeckt die photovoltaische Absorberschicht lückenlos; die oxidische Passivierungsschicht ist geschlossen. Außer der frontkontaktseitigen Oberfläche, an die der Dotierbereich angrenzt, kann die photovoltaische Absorberschicht eine gegenüberliegende Grenzfläche z.B. mit einer elektrischen Rückkontaktschicht aufweisen.

In der Regel macht das eindotierte Alkalimetall ein Absorberschichtmaterial unter Umgebungsbedingungen anfälliger für eine chemische Korrosion wenigstens in dem Bereich an der Oberfläche, insbesondere wenn die Absorberschicht Verbindungshalbleitermaterialien umfasst. Die Korrosion beeinträchtigt die optoelektronischen Eigenschaften der Dünnschichtsolarzelle. Durch die Korrosion können als Folge von Redox-Vorgängen durch Elektronenaustausch mit atmosphärischem Sauerstoff bzw. von Hydrolyse-Prozessen durch Wechselwirkung mit Feuchtigkeit der Umgebungsluft an der Oberfläche der photovoltaischen Absorberschicht Materialdefekte entstehen, begleitet von der Bildung von räumlich verteilten einzelnen Oxiden. Diese Materialdefekte führen zu einer Erhöhung der Rekombination lichtinduzierter Ladungsträger. Die räumlich verteilten Oxide wirken nicht passivierend. Sie schützen die photovoltaische Absorberschicht auch nicht vor einer weiteren Korrosion, insbesondere im Volumen der photovoltaischen Absorberschicht unterhalb der Oberfläche, beispielsweise entlang von Korngrenzen einer polykristallinen Absorberschichtstruktur.

Häufig wird alternativ zu einer konventionellen CdS-Pufferschicht (Cadmiumsulfid CdS) während der weiteren Prozessierung der Dünnschichtsolarzelle auf die photovoltaische Absorberschicht mindestens eine sauerstoffhaltige Pufferschicht aufgebracht. Typischerweise enthält die Pufferschicht ein oxidisches (z.B. Zinkoxid ZnO, Zinkmagnesiumoxid ZnMgO) und/oder oxosulfidisches (z.B. Zinkoxosulfid Zn(O,S)) Material oder besteht aus mindestens einem dieser Materialien. Diese rein bzw. partiell oxidischen Materialien oder aufgebrachten sauerstoffhaltigen Pufferschichten sind nicht in der Lage, die photovoltaische Absorberschicht ausreichend vor Korrosion zu schützen.

Die erfindungsgemäße oxidische Passivierungsschicht ermöglicht einen guten Schutz der photovoltaischen Absorberschicht, welche die Alkalimetalldotierung aufweist, vor Korrosion und damit verbunden vor der Bildung von elektrisch aktiven Störstellen, insbesondere während einer weiteren Schichtaufbau- bzw. Dünnschichtsolarzellenprozessierung vor einer Verkapselung der Dünnschichtsolarzelle bzw. im Falle einer nichtperfekt dichtenden Verkapselung darüber zeitlich hinaus. Vor Korrosion schützen umfasst, dass der Korrosionsprozess mindestens zeitlich verzögert wird. Des Weiteren erlaubt es die oxidische Passivierungsschicht, die Rekombination von lichtinduzierten Ladungsträgern an der Oberfläche der photovoltaischen Absorberschicht zu verringern oder zu verhindern. Insbesondere kann die oxidische Passivierungsschicht dazu ausgebildet sein, einen Photostromverlust an der Oberfläche oder Grenzfläche der photovoltaischen Absorberschicht zu verhindern. In anderen Worten kann die oxidische Passivierungsschicht dazu ausgebildet sein, ungesättigte Bindungen, sogenannte "dangling bonds", zu sättigen, insbesondere durch Bildung von Sauerstoff-Verbindungen, eine Bildung positiver Ladungen an der Oberfläche oder Grenzfläche zu verhindern und/oder eine elektrische Aktivität der Oberfläche zu vermeiden. Somit können die Vorteile der Alkalimetalldotierung genutzt und deren Nachteile vermieden werden, wodurch der Wirkungsgrad der so hergestellten Dünnschichtsolarzelle besonders hoch ist und idealerweise während der gesamten Lebensdauer der Dünnschichtsolarzelle hoch bleibt. Darüber hinaus kann das Aufbringen einer Pufferschicht, z.B. aus CdS, Zn(O,S) oder In₂S₃, durch die oxidische Passivierungsschicht begünstigt werden, womit die Qualität der Pufferschicht verbessert sein kann und somit eine Dicke der Pufferschicht verringert werden kann. Des Weiteren kann die oxidische Passivierungsschicht als schwache Diffusionsbarriere gegen Atom-/lonendiffusion im Grenzflächenbereich zwischen photovoltaischer Absorberschicht und Pufferschicht wirken.

Erfindungsgemäß weist die photovoltaische Absorberschicht ein Chalkopyritmaterial, und zwar Cu(In₁₋ₓGaₓ)(Se_{1-y}S_{y})₂ (Kupfer Cu, Indium In, Gallium Ga, Selen Se, Schwefel S) mit 0≤x,y≤1, oder ein Kesteritmaterial, und zwar Cu₂ZnSn(Se₁₋ₓSₓ)₄ (Zinn Sn) mit 0≤x≤1 auf oder besteht aus einem dieser Materialien. Diese Verbindungshalbleitermaterialen haben direkte elektrische Bandlücken von wenigen eV (Elektronenvolt). Des Weiteren lassen sie sich gut mit Alkalimetallen dotieren. Somit sind sie zum Einsatz in Dünnschichtsolarzellen optimal geeignet.

Typischerweise sind Verbindungshalbleiterschichten aufgrund intrinsischer Defekte leicht p-dotiert. Herkömmlicherweise wird eine p-n-Inversion in der Dünnschichtsolarzelle durch Aufbringen einer mit Al (Aluminium) stark n-dotierten ZnO-Schicht auf die mindestens eine zuvor erwähnte Pufferschicht erreicht. Mittels der p-n-Inversion wird ein über die Schichten der Dünnschichtsolarzelle abfallendes elektrisches Feld erzeugt und durch Photonenabsorption erzeugte Elektron-Loch-Paare können dadurch räumlich getrennt werden. In einer Weiterbildung der Erfindung ist der an die Oberfläche der photovoltaischen Absorberschicht angrenzende Bereich derart dotiert, dass er eine p-n-Inversion aufweist. Dies kann durch ein geeignetes Dotierprofil mit einer entsprechend hohen Dotierung über den Dotierbereich hinweg erreicht werden. Dadurch können in der photovoltaischen Absorberschicht erzeugte Elektron-Loch-Paare noch effektiver getrennt werden. Insbesondere kann eine Rekombination der Elektron-Loch-Paare verringert werden. Somit kann eine Erhöhung des Wirkungsgrades der Dünnschichtsolarzelle erreicht werden. Vorteilhafterweise kann die photovoltaische Absorberschicht an der Oberfläche n-dotiert sein.

Zur Dotierung der photovoltaischen Absorberschicht werden bislang die Alkalimetalle Natrium (Na) und Kalium (K) benutzt. Mit Na wird in der Regel keine p-n-Inversion in dem Bereich an der Oberfläche erreicht. Eine Steigerung des Wirkungsgrades der Dünnschichtsolarzelle mit K ist volatil, d.h. die Reproduzierbarkeit solcher Dünnschichtsolarzellen mit hohem Wirkungsgrad ist gering. In einer Weiterbildung der Erfindung ist das mindestens eine Alkalimetall Rubidium Rb und/oder Caesium Cs. Diese Alkalimetalle können an der Oberfläche der photovoltaischen Absorberschicht fixiert werden, wodurch eine p-n-Inversion in dem Bereich an der Oberfläche der photovoltaischen Absorberschicht erreicht werden kann. Überraschenderweise zeigt sich, dass sich der Wirkungsgrad von Dünnschichtsolarzellen mit diesen speziellen Alkalimetallen deutlich erhöhen lässt und die Reproduzierbarkeit der erhöhten Wirkungsgrade verbessert ist.

Erfindungsgemäß umfasst im Fall des Chalkopyritmaterials für die Absorberschicht die oxidische Passivierungsschicht (In,Ga)₂O₃ und/oder Mₓ(In,Ga)_{y}O_{z} (Sauerstoff O) mit M=K, Rb, Cs und mit 0<x, y, z und optional zusätzlich Aluminiumoxid Al₂O₃. Alternativ umfasst im Fall des Kesteritmaterials für die Absorberschicht die oxidische Passivierungsschicht SnOₓ mit x= 1 bis 2, wobei auch Alkalimetall-Anteile durch Diffusion aus der Oberfläche oder Grenzfläche enthalten sein können. In anderen Worten liegen die genannten Materialien vorzugsweise jeweils nicht in Dotiermengenkonzentration vor, sondern in stöchiometrischen Mengen. Für eine photovoltaische Absorberschicht, die aus einem Chalkopyritmaterial, und zwar aus Cu(In₁₋ₓGaₓ)(Se_{1-y}S_{y})₂ mit 0≤x, y≤1, besteht oder dieses enthält, wird die oxidische Passivierungsschicht mit (In,Ga)₂O₃ und/oder Mₓ(In,Ga)_{y}O_{z} aus der photovoltaischen Absorberschicht und Sauerstoff erzeugt oder gewachsen; dabei wird die Oberfläche der photovoltaischen Absorberschicht umgewandelt.

Für eine photovoltaische Absorberschicht, die aus einem Kesteritmaterial, und zwar aus Cu₂ZnSn(Se₁₋ₓSₓ)₄ mit 0≤x≤1, besteht oder dieses enthält, wird die oxidische Passivierungsschicht mit SnOₓ aus der photovoltaischen Absorberschicht und Sauerstoff erzeugt oder gewachsen; dabei wird die Oberfläche der photovoltaischen Absorberschicht umgewandelt. Zusätzlich kann die oxidische Passivierungsschicht mit Al₂O₃ durch ein Aufbringen von Al₂O₃ erzeugt werden. Insbesondere kann Al₂O₃ nicht nur Al-Schichten, sondern auch andere Materialschichten vor Korrosion schützen.

In einer Weiterbildung der Erfindung liegt eine Dicke der oxidischen Passivierungsschicht im Bereich von 1 nm bis 50 nm (Nanometer), insbesondere im Bereich von 3 nm bis 5 nm. Dadurch kann einerseits ein guter Schutz der photovoltaischen Absorberschicht vor Korrosion erreicht werden. Andererseits kann noch ein guter elektrischer Transport von der photovoltaischen Absorberschicht durch die oxidische Passivierungsschicht hindurch zu einer optionalen Pufferschicht bzw. einer Frontkontaktschicht gewährleistet werden. Im Falle einer Erzeugung oder eines Wachstums der oxidischen Passivierungsschicht aus der photovoltaischen Absorberschicht und Sauerstoff wird diese/dieses durch die Anwesenheit des mindestens einen Alkalimetalls begünstigt, insbesondere durch Rb und/oder Cs, so dass die Dicke im genannten Bereich ohne Schädigung des restlichen Teils der photovoltaischen Absorberschicht erreicht werden kann. Dahingegen ist bei einer photovoltaischen Absorberschicht ohne Alkalimetalldotierung ein Wachstum einer Oxidschicht mit einer Dicke oberhalb eines Submonolagenbereichs aus dieser und Sauerstoff gar nicht erst möglich oder, wenn es mittels hoher Temperaturen und langer Wachstumszeitdauern erzwungen wird, findet es unter Schädigung der photovoltaischen Absorberschicht statt, wobei die Oxidschicht dann nicht geschlossen ist und auch nicht passivierend wirkt. Schädigung der photovoltaischen Absorberschicht bedeutet, dass die photovoltaische Absorberschicht ihre halbleitenden Eigenschaften verliert und damit nicht mehr für eine Dünnschichtsolarzelle zu gebrauchen ist.

Bei dem erfindungsgemäßen Verfahren zur Herstellung des erfindungsgemäßen Schichtaufbaus wird in einem Schritt a die photovoltaische Absorberschicht, die wenigstens in dem an die frontkontaktseitige Oberfläche der photovoltaischen Absorberschicht angrenzenden Bereich mit dem mindestens einen Alkalimetall dotiert ist, auf einer Unterlage erzeugt. Außerdem wird gleichzeitig oder danach in einem Schritt b die oxidische Passivierungsschicht an der frontkontaktseitigen Oberfläche der photovoltaischen Absorberschicht gebildet, und zwar derart, dass sie die photovoltaische Absorberschicht vor Korrosion und damit verbunden vor der Bildung von elektrisch aktiven Störstellen schützt. Insbesondere umfasst der Schritt b hierfür ein Einbauen der oxidischen Passivierungsschicht an der frontkontaktseitigen Oberfläche in die photovoltaische Absorberschicht, wozu die photovoltaische Absorberschicht an der frontkontaktseitigen Oberfläche umgewandelt wird. Außerdem kann sich der Schritt b unmittelbar an den Schritt a anschließen, d. h. ohne einen Schritt dazwischen. Der Schritt a kann ein Wachsen der photovoltaischen Absorberschicht auf einem mit dem mindestens einen Alkalimetall versetzten Substrat und ein Eindiffundieren des mindestens einen Alkalimetalls aus dem Substrat in die photovoltaische Absorberschicht bei höheren Temperaturen umfassen. Alternativ oder zusätzlich kann der Schritt a ein Aufbringen eines Alkalimetallfluoridvorläufers auf ein Substrat, ein Wachsen der photovoltaischen Absorberschicht auf dem Substrat und ein Eindiffundieren des mindestens einen Alkalimetalls aus dem Alkalimetallfluoridvorläufer in die photovoltaische Absorberschicht bei höheren Temperaturen umfassen.

In einer Weiterbildung der Erfindung umfasst der Schritt a als einen Unterschritt ax das Erzeugen einer photovoltaischen Absorberschicht, und als einen Unterschritt az ein Dotieren der photovoltaischen Absorberschicht wenigstens in dem an die Oberfläche der photovoltaischen Absorberschicht angrenzenden Bereich mit dem mindestens einen Alkalimetall. Der Unterschritt az kann mit dem Unterschritt ax beginnen oder nach diesem beginnen, bevor oder nachdem der Schritt ax vollständig abgeschlossen ist. Außerdem kann der Unterschritt az gleichzeitig mit dem Unterschritt ax oder nach diesem aufhören. Das mindestens eine Alkalimetall kann mittels eines Alkalimetallfluorids, z.B. RbF und/oder CsF, und/oder anderer Alkalimetallverbindungen, z.B. Alkalimetalloxide, Alkalimetallcarbonate, Alkalimetallselenide und/oder anderer Alkalimetallhalogenide, wie RbCl, CsCl, RbBr, CsBr, Rbl und/oder Csl, bereitgestellt werden. Mit diesem Verfahren kann insbesondere mit Rb und/oder Cs eine p-n-Inversion in dem an die Oberfläche der photovoltaischen Absorberschicht angrenzenden Bereich erzeugt werden.

In einer Ausgestaltung der Erfindung kann das Verfahren einen Schritt zum Aufbringen des mindestens einen Alkalimetalls auf die Oberfläche der photovoltaischen Absorberschicht umfassen. Der Schritt ax kann vollständig vor diesem Schritt abgeschlossen sein, der dann als ein Post-Deposition-Treatment (PDT) bezeichnet werden kann. Das Alkalimetall kann beispielsweise als Alkalimetallfluorid und/oder als andere Alkalimetallverbindung unter Se-Atmosphäre und/oder S-Atmosphäre auf die Oberfläche des photovoltaischen Absorbers aufgedampft werden. Gleichzeitig oder danach kann der Schritt az in Form von Eindiffundieren des mindestens einen Alkalimetalls wenigstens in den an die Oberfläche der photovoltaischen Absorberschicht angrenzenden Bereich durchgeführt werden, insbesondere und teilweise gezwungenermaßen unter Se-Atmosphäre und/oder S-Atmosphäre. Dabei kann die photovoltaische Absorberschicht auf mindestens 350 °C erwärmt werden. Im Falle eines Alkalimetallfluorids kann beim Aufdampfen und Eindiffundieren unter Se-Atmosphäre und/oder S-Atmosphäre das Fluor eine chemische Bindung mit Se und/oder S außerhalb der photovoltaischen Absorberschicht eingehen, so dass nur das Alkalimetall und nicht F in die photovoltaische Absorberschicht eindiffundieren kann. Für andere Alkalimetallverbindungen kann ein ähnlicher Mechanismus stattfinden.

Gemäß der Erfindung umfasst der Schritt b ein Tempern der alkalimetalldotierten Absorberschicht bei gegenüber Raumtemperatur erhöhter Temperatur in einer sauerstoffhaltigen Atmosphäre. Dadurch wird bei einer photovoltaischen Absorberschicht, die aus einem Chalkopyrit, und zwar aus Cu(In₁₋ₓGaₓ)(Se_{1-y}S_{y})₂ mit 0≤x, y≤1, besteht oder dieses enthält, die oxidische Passivierungsschicht mit (In,Ga)₂O₃, Mₓ(In,Ga)_{y}O_{z} erzeugt oder gewachsen; dabei wird die Oberfläche der photovoltaischen Absorberschicht umgewandelt.

Alternativ wird dadurch bei einer photovoltaischen Absorberschicht, die aus einem Kesteritmaterial, und zwar aus Cu₂ZnSn(Se₁₋ₓSₓ)₄ mit 0≤x≤1, besteht oder dieses enthält, die oxidische Passivierungsschicht mit SnO₂ erzeugt oder gewachsen; dabei wird die Oberfläche der photovoltaischen Absorberschicht umgewandelt werden. Die SnOₓ- Oxidschicht kann durch Diffusionsprozesse an der Oberfläche oder Grenzfläche auch Alkalimetalle umfassen. Gegenüber Raumtemperatur ist die Temperatur für den Temperprozess um mindestens 80 Kelvin erhöht. Bevorzugt kann das Tempern bei mindestens ca. 120 °C, insbesondere in einem Bereich von 120 °C bis 250 °C, durchgeführt werden. Das Tempern kann mindestens 1 Minute bis maximal 30 Minuten betragen. Das Tempern kann bei einem Sauerstoff-Partialdruck von mindestens 10⁻¹ mbar, insbesondere in einem Bereich von 1 mbar bis zu Umgebungsluft-Sauerstoffpartialdruck, durchgeführt werden.

In einer Weiterbildung der Erfindung umfasst der Schritt b ein Aufbringen eines Oxids auf die Oberfläche der photovoltaischen Absorberschicht mit Alkalimetalldotierung. Insbesondere kann das Oxid Al₂O₃ umfassen.

In einer Weiterbildung der Erfindung umfasst das Verfahren einen Schritt zum Aufbringen der Pufferschicht, z.B. aus CdS, Zn(O,S) oder In₂S₃, auf der oxidischen Passivierungsschicht.

Vorteilhafte Ausführungsformen der Erfindung sind in den Zeichnungen dargestellt und werden nachfolgend beschrieben: Hierbei zeigen:
- Fig. 1: einen schematische Querschnittansicht durch eine Dünnschichtsolarzelle und
- Fig. 2: ein Flussdiagramm eines Verfahrens zur Herstellung der Dünnschichtsolarzelle der Fig. 1.

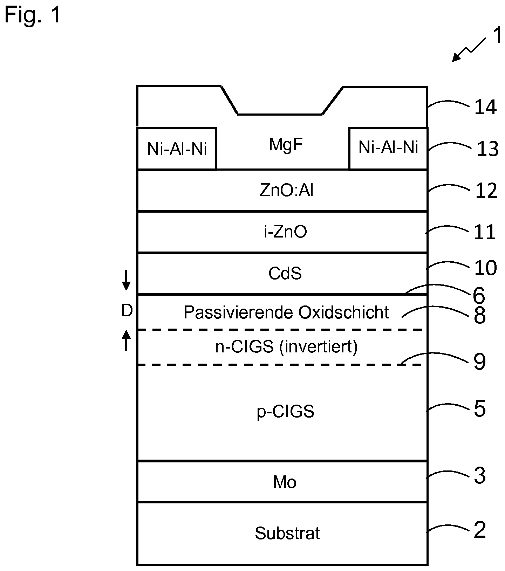

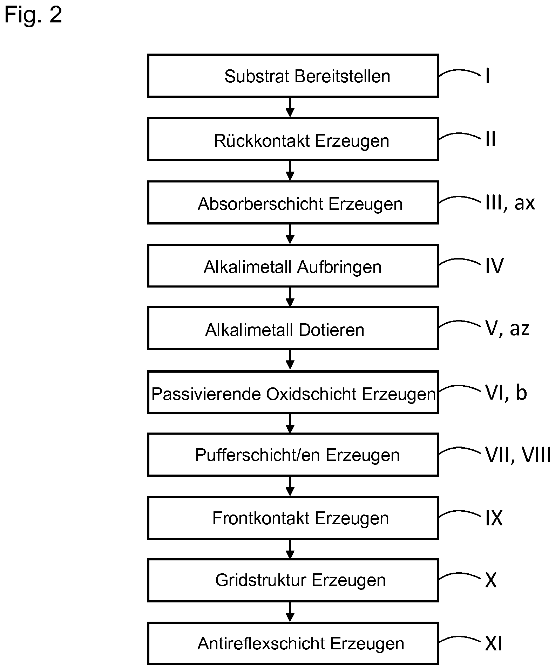

Fig. 1 zeigt eine schematische Querschnittansicht durch eine Dünnschichtsolarzelle 1 gemäß einer vorteilhaften Ausführungsform. Fig. 2 zeigt im Flussdiagramm die hier interessierenden wesentlichen Schritte eines exemplarischen Herstellungsverfahrens für die Dünnschichtsolarzelle 1. In einem ersten Schritt I wird ein Substrat 2 z.B. aus Glas bereitgestellt. In einem zweiten Schritt II wird eine Mo-Schicht 3 (Molybdän), die als Rückkontakt der Dünnschichtsolarzelle 1 dienen soll, per Kathodenzerstäubung (Sputtern) im Vakuum auf das Glassubstrat 2 aufgebracht, z.B. in einer Dicke von ca. 500 nm.

Danach werden in einem Koverdampfungsprozess (Schritt III, ax) die Elemente Cu, In, Ga und Se bei einer Temperatur des Glassubstrats 2 von z.B. ca. 600 °C aufgedampft. Auf diese Weise wächst eine photovoltaische Absorberschicht 5 bestehend aus dem Verbindungshalbleitermaterial Cu(In₁₋ₓGaₓ)(Se_{1-y}S_{y})₂ mit 0≤x, y≤1 auf der Mo-Schicht 3, z.B. in einer Dicke von 2 µm bis 3 µm (Mikrometer). Die photovoltaische Absorberschicht 5 ist zu diesem Zeitpunkt aufgrund intrinsischer Defekte im CIGS-Material und aufgrund einer möglichen extrinsischen Dotierung mit Natrium und Kalium aus dem Glassubstrat, falls dort vorhanden, überall leicht p-dotiert.

Nach dem Erzeugen der photovoltaischen Absorberschicht 5 wird im Vakuum RbF und/oder CsF aus einem Verdampfungstiegel bei Tiegeltemperaturen von mindestens etwa 400 °C auf eine Oberfläche 6 der photovoltaischen Absorberschicht 5 aufgedampft (Schritt IV). Das mindestens eine Alkalimetall diffundiert bei leicht erhöhter Temperatur des Glassubstrats 2 von ca. mindestens 350 °C in die photovoltaische Absorberschicht 5 ein (Schritt V, az). Dabei verdrängen Rb- und/oder Cs-Atome/lonen auf Grund ihres größeren lonenradius irreversibel Cu-Atome von der Oberfläche 6 in Richtung der Molybdänschicht 3 ins Volumen der photovoltaischen Absorberschicht 5. Die höchste Alkalimetallkonzentration findet sich aufgrund dieses Austauschs oberflächennah in der photovoltaischen Absorberschicht 5. Dies führt zu einer p-n-Inversion 9 in der photovoltaischen Absorberschicht 5 in der Nähe der Oberfläche 6. In das Volumen der photovoltaischen Absorberschicht 5 dringt das Rb oder Cs bevorzugt entlang von Korngrenzen des CIGS-Materials bis hin zur Molybdänschicht 3 ein und kann dort teilweise Natrium und Kalium verdrängen, falls vorhanden. Die Schritte IV und V sind in diesem Fall PDT-Prozesse. In einer alternativen Ausführungsform kann RbF und/oder CsF unter Se-Atmosphäre und/oder S-Atmosphäre aufgedampft werden. Alternativ oder zusätzlich kann das mindestens eine Alkalimetall unter Se-Atmosphäre und/oder S-Atmosphäre in die photovoltaische Absorberschicht eindiffundieren.

Danach wird eine oxidische Passivierungsschicht 8 an der Oberfläche 6 der photovoltaischen Absorberschicht 5 durch ein Tempern des bis dahin erzeugten Schichtaufbaus an Umgebungsluft erzeugt (Schritt VI, b), z.B. bei ca. 200 °C. Dabei wird Sauerstoff an der Oberfläche 6 in das alkalimetalldotiere CIGS-Material eingebaut; die photovoltaische Absorberschicht 5 wird an der Oberfläche 6 umgewandelt. Die oxidische Passivierungsschicht 8 umfasst dann die Materialien (In,Ga)₂O₃ und Mₓ(In,Ga)_{y}O_{z} mit M=Rb und/oder Cs und mit 0<x, y, z. Die oxidische Passivierungsschicht 8 erstreckt sich über eine Dicke D von z.B. ca. 3 nm bis 5 nm in die photovoltaische Absorberschicht 5 in Fig. 1 nach unten hinein. Die oxidische Passivierungsschicht 8 schützt den größeren restlichen Teil der photovoltaischen Absorberschicht 5 vor Korrosion, insbesondere während der weiteren Herstellung der Dünnschichtsolarzelle 1.

Anschließend wird eine ca. 30 nm bis 50 nm dicke CdS-Pufferschicht 10 in einem chemischen Tauchbad auf der Oberfläche 6 der photovoltaischen Absorberschicht 5 bzw. der oxidischen Passivierungsschicht 8 aufgewachsen bzw. abgeschieden (Schritt VII). Dabei begünstigt die oxidische Passivierungsschicht 8 wegen einer Veränderung der Oberflächenpolarität der Absorberschicht 5 das Wachstum der CdS-Pufferschicht 10 und verbessert deren Qualität.

Darauf folgt eine ca. 50 nm bis 100 nm dicke undotierte i-ZnO-Schicht 11 durch Sputtern im Vakuum (Schritt VIII) und eine mit Aluminium stark n-dotierte ca. 150 nm bis 250 nm dicke ZnO:Al-Schicht 12 (Schritt IX). Die CdS-Pufferschicht 10 und die i-ZnO-Schicht 11 gewährleisten eine Bandanpassung zwischen dem CIGS-Material der photovoltaischen Absorberschicht 5 und der ZnO:Al-Schicht 12. Die ZnO:Al-Schicht 12 ist transparent und leitfähig und soll als Frontkontakt der Dünnschichtsolarzelle 1 dienen.

Auf die ZnO:Al-Schicht 12 werden eine etwa mehrere µm dicke Ni-Al-Ni Gridstruktur 13 (Nickel Ni) (Schritt X) und eine Antireflexschicht 14 aus MgF (Schritt XI) aufgebracht.

An einer wie beschrieben hergestellten Dünnschichtsolarzelle 1 konnten Wirkungsgrade von bis zu 21,7 % gemessen werden.

In der gezeigten Ausführungsform umfasst die photovoltaische Absorberschicht CIGS-Material, und zwar Cu(In₁₋ₓGaₓ)(Se_{1-y}S_{y})₂ mit 0≤x, y≤1.

Alternativ umfasst oder besteht die photovoltaische Absorberschicht aus Cu₂ZnSn(Se₁₋ₓSₓ)₄, die durch Koverdampfung der genannten Elemente oder Selenisierung/Sulfurisierung von Präkursorschichten auf ein Mo-beschichtetes Substrat (z.B. Glas, Metall, Keramik, Kunststoff) hergestellt werden kann.

Des Weiteren muss die photovoltaische Absorberschicht nicht vollständig dotiert sein oder eine p-n-Inversion aufweisen; wenigstens ein Bereich, der an die Oberfläche der photovoltaischen Absorberschicht angrenzt, ist mit dem mindestens einen Alkalimetall dotiert. Außerdem kann die Dotierung der photovoltaischen Absorberschicht mit mindestens einem Alkalimetall in wenigstens einem an die Oberfläche der photovoltaischen Absorberschicht angrenzenden Bereich durch andere herkömmliche Prozesse anstelle des erwähnten PDT-Prozesses erzeugt werden.

Außerdem kann alternativ oder zusätzlich zu RbF und/oder CsF das mindestens eine Alkalimetall mittels eines anderen Alkalimetallfluorids und/oder anderer Alkalimetallverbindungen, z.B. Alkalimetalloxide, Alkalimetallcarbonate, Alkalimetallselenide und/oder anderer Alkalimetallhalogenide, wie RbCl, CsCl, RbBr, CsBr, Rbl und/oder Csl, bereitgestellt werden.

Die oxidische Passivierungsschicht für Cu(In₁₋ₓGaₓ)(Se_{1-y}S_{y})₂ mit 0≤x, y≤1 kann zusätzlich zu den Materialien (In,Ga)₂O₃ und Mₓ(In,Ga)_{y}O_{z} mit M=Rb und/oder Cs das Material Al₂O₃ umfassen, wobei Al₂O₃ auf die Oberfläche der photovoltaischen Absorberschicht aufgebracht werden kann. Alternativ für eine photovoltaische Absorberschicht, die aus einem Kesteritmaterial, und zwar aus Cu₂ZnSn(Se₁₋ₓSₓ )4 mit 0≤x≤1, besteht oder dieses enthält, umfasst oder besteht die oxidische Passivierungsschicht aus SnOₓ mit x= 1 bis 2, wobei auch Alkalimetall-Anteile durch Diffusion aus der Oberfläche oder Grenzfläche enthalten sein können.

Die auf die oxidische Passivierungsschicht aufgebrachte Pufferschicht kann alternativ oder zusätzlich zu CdS ein anderes Material, insbesondere Zn(O,S) und/oder In₂S₃, umfassen oder aus diesem bestehen, welches in einem chemischen Tauchbad oder durch einen Gasphasenprozess abgeschieden werden kann.

Die auf die CdS-Pufferschicht aufgebrachte Schicht kann alternativ oder zusätzlich zu i-ZnO-Material i-Zn₁₋ₓMgₓO mit 0≤x≤0,4 umfassen oder aus diesem Material bestehen, welches ähnlich wie das i-ZnO durch Kathodenzerstäubung aufgebracht werden kann.

Durch Optimierung der Dicke und der optoelektronischen Eigenschaften der passivierenden Oxidschicht (Materialkombination, Dotierung, Bandlücke, etc.) kann diese nicht nur chemische Anforderungen (z.B. Schutz der photovoltaischen Absorberschicht vor Korrosion) erfüllen, sondern darüber hinaus auch physikalische Anforderungen erfüllen, wie z.B. eine Bandanpassung zwischen dem Material der photovoltaischen Absorberschicht und der Schicht des Frontkontakts. Somit kann die nachfolgende Pufferschicht und/oder die i-ZnO- bzw. die ZnMgO-Schicht weggelassen werden. Es wurden bereits mehrfach herkömmliche CIGS-Solarzellen demonstriert, bei denen aufgrund einer Optimierung der Dicke und des Abscheideverfahrens der CdS- und/oder Zn(O,S)-Pufferschicht die nachfolgende i-ZnO- bzw. i-ZnMgO-Schicht weggelassen werden konnte.

Wie die gezeigten und oben erläuterten Ausführungsformen deutlich machen, stellt die Erfindung einen vorteilhaften Schichtaufbau für eine Dünnschichtsolarzelle zu Verfügung, der eine oxidische Passivierungsschicht an einer Oberfläche einer photovoltaischen Absorberschicht derart aufweist, so daß sie in der photovoltaische Absorberschicht eingebaut ist, und die dazu ausgebildet ist, die photovoltaische Absorberschicht vor Korrosion zu schützen, womit eine Steigerung des Wirkungsgrads der Dünnschichtsolarzelle ermöglicht wird.

## Patentansprüche

1. Schichtaufbau für eine Dünnschichtsolarzelle mit
- einer photovoltaischen Absorberschicht (5), die wenigstens in einem an eine frontkontaktseitige Oberfläche (6) der photovoltaischen Absorberschicht angrenzenden Bereich mit mindestens einem Alkalimetall dotiert ist, und
- einer oxidischen Passivierungsschicht (8) an der frontkontaktseitigen Oberfläche (6) der photovoltaischen Absorberschicht (5), wobei die oxidische Passivierungsschicht eine Korrosionsschutzschicht für die photovoltaische Absorberschicht ist und an der frontkontaktseitigen Oberfläche (6) in die photovoltaische Absorberschicht (5) eingebaut ist, wobei die photovoltaische Absorberschicht an der Oberfläche (6) umgewandelt ist,
- wobei die photovoltaische Absorberschicht (5) Cu(In₁₋ₓGaₓ)(Se_{1-y}S_{y})₂ mit 0≤x,y≤1 aufweist und die oxidische Passivierungsschicht (8) (In,Ga)₂O₃ und/oder Mₓ(In,Ga)_{y}O_{z} mit M=K, Rb, Cs und mit 0<x, y, z umfasst oder
- wobei die photovoltaische Absorberschicht (5) Cu₂ZnSn(Se₁₋ₓSₓ)₄ mit 0≤x≤1 aufweist und die oxidische Passivierungsschicht (8) SnOₓ mit x= 1 bis 2 umfasst.

2. Schichtaufbau nach Anspruch 1, **dadurch gekennzeichnet, dass** der an die frontkontaktseitige Oberfläche (6) der photovoltaischen Absorberschicht (5) angrenzende Bereich derart dotiert ist, dass er eine p-n-Inversion (9) aufweist.

3. Schichtaufbau nach Anspruch 1 oder 2, **dadurch gekennzeichnet, dass** das mindestens eine Alkalimetall Rubidium und/oder Caesium ist.

4. Schichtaufbau nach einem der Ansprüche 1 bis 3, **dadurch gekennzeichnet, dass** die oxidische Passivierungsschicht zusätzlich Al₂O₃ umfasst.

5. Schichtaufbau nach einem der Ansprüche 1 bis 4, **dadurch gekennzeichnet, dass** eine Dicke (D) der oxidischen Passivierungsschicht (8) im Bereich von 1 nm bis 50 nm liegt.

6. Schichtaufbau nach einem der Ansprüche 1 bis 5, **dadurch gekennzeichnet, dass** auf der oxidischen Passivierungsschicht (8) eine Pufferschicht (10) aufgebracht ist.

7. Verfahren zur Herstellung eines Schichtaufbaus für eine Dünnschichtsolarzelle nach einem der Ansprüche 1 bis 6 mit den Schritten:
a. Erzeugen einer photovoltaischen Absorberschicht (5), die wenigstens in einem an eine frontkontaktseitige Oberfläche (6) der photovoltaischen Absorberschicht angrenzenden Bereich mit mindestens einem Alkalimetall dotiert ist, auf einer Unterlage und
b. Erzeugen einer oxidischen Passivierungsschicht (8) an der Oberfläche der photovoltaischen Absorberschicht, wobei die oxidische Passivierungsschicht eine Korrosionsschutzschicht für die photovoltaische Absorberschicht ist, wobei der Schritt b ein Einbauen der oxidischen Passivierungsschicht (8) an der frontkontaktseitigen Oberfläche (6) in die photovoltaische Absorberschicht (5) umfasst, wobei die photovoltaische Absorberschicht (5) an der Oberfläche (6) umgewandelt wird.

8. Verfahren nach Anspruch 7, **dadurch gekennzeichnet, dass** der Schritt a die folgenden Unterschritte umfasst:
ax. Erzeugen der photovoltaischen Absorberschicht (5) und
az. Dotieren der photovoltaischen Absorberschicht wenigstens in dem an die frontkontaktseitige Oberfläche (6) der photovoltaischen Absorberschicht angrenzenden Bereich mit dem mindestens einen Alkalimetall.

9. Verfahren nach Anspruch 8, **gekennzeichnet durch** einen Schritt zum Aufbringen des mindestens einen Alkalimetalls auf die frontkontaktseitige Oberfläche (6) der photovoltaischen Absorberschicht (5), wobei der Schritt az ein Eindiffundieren des mindestens einen Alkalimetalls wenigstens in den an die Oberfläche der photovoltaischen Absorberschicht angrenzenden Bereich umfasst, insbesondere unter Se-Atmosphäre und/oder S-Atmosphäre.

10. Verfahren nach einem der Ansprüche 7 bis 9, **dadurch gekennzeichnet, dass** der Schritt b ein Tempern bei gegenüber Raumtemperatur erhöhter Temperatur der photovoltaischen Absorberschicht (5) mit Alkalimetalldotierung in einer Sauerstoff-haltigen Atmosphäre umfasst, wobei insbesondere die oxidische Passivierungsschicht (8) aus der photovoltaischen Absorberschicht und Sauerstoff erzeugt wird.

11. Verfahren nach einem der Ansprüche 7 bis 10, **dadurch gekennzeichnet, dass** der Schritt b ein Aufbringen von einem Oxid auf die frontkontaktseitige Oberfläche (6) der photovoltaischen Absorberschicht (5) mit Alkalimetalldotierung umfasst.

12. Verfahren nach einem der Ansprüche 7 bis 11, **gekennzeichnet durch** einen Schritt zum Aufbringen einer Pufferschicht (10) auf der oxidischen Passivierungsschicht (8).

## Claims

1. Layer structure for a thin-film solar cell, comprising
- a photovoltaic absorber layer (5) doped, at least in a region bordering a front-contact-side surface (6) of the photovoltaic absorber layer, with at least one alkali metal, and
- an oxidic passivating layer (8) on the of the photovoltaic absorber layer (5), the oxidic passivating layer being a corrosion protection layer for the photovoltaic absorber layer and built-in into the photovoltaic absorber layer at the front-contact-side surface (6), wherein the photovoltaic absorber layer is converted at the surface (6),
- wherein the photovoltaic absorber layer (5) comprises Cu(In₁₋ₓGaₓ)(Se_{1-y}S_{y})₂, where 0 ≤ x,y ≤ 1, and the oxidic passivating layer (8) comprises In,Ga)₂O₃ and/or Mₓ(In,Ga)_{y}O_{z}, where M = K, Rb, Cs and where 0 < x, y, z, or
- wherein the photovoltaic absorber layer (5) comprises Cu₂ZnSn(Se₁₋ₓSₓ)₄, where 0 ≤ x ≤ 1, and the oxidic passivating layer (8) comprises SnOₓ, where x = 1 to 2.

2. Layer structure according to claim 1, **characterized in that** the region bordering the front-contact-side surface (6) of the photovoltaic absorber layer (5) is doped such that it exhibits a p-n inversion (9).

3. Layer structure according to claim 1 or 2, **characterized in that** the at least one alkali metal is rubidium and/or cesium.

4. Layer structure according to any one of claims 1 to 3, **characterized in that** the oxidic passivating layer further comprises Al₂O₃.

5. Layer structure according to any one of claims 1 to 4, **characterized in that** a thickness (D) of the oxidic passivating layer (8) is in the range from 1 nm to 50 nm.

6. Layer structure according to any one of claims 1 to 5, **characterized in that** a buffer layer (10) is formed on the oxidic passivating layer (8).

7. Method for manufacturing a layer structure for a thin-film solar cell, as claimed in any one of claims 1 to 6, comprising the steps:
a. generating a photovoltaic absorber layer (5), doped, at least in a region bordering a front-contact-side surface (6) of the photovoltaic absorber layer, with at least one alkali metal, on a substrate, and
b. generating an oxidic passivating layer (8) on the surface of the photovoltaic absorber layer, the oxidic passivating layer being a corrosion protection layer for the photovoltaic absorber layer, wherein step b comprises to build-in the oxidic passivating layer (8) into the photovoltaic absorber layer (5) at the front-contact-side surface (6), wherein the photovoltaic absorber layer is converted on the surface (6).

8. Method according to claim 7, **characterized in that** step a comprises the following substeps:
ax. generating the photovoltaic absorber layer (5) and
az. doping the photovoltaic absorber layer, at least in the region bordering the front-contact-side surface (6) of the photovoltaic absorber layer, with the at least one alkali metal.

9. Method according to claim 8, **characterized by** a step for forming the at least one alkali metal on the front-contact-side surface (6) of the photovoltaic absorber layer (5), the step az comprising to diffuse the at least one alkali metal at least into the region bordering the surface of the photovoltaic absorber layer, preferably under an Se atmosphere and/or S atmosphere.

10. Method according to any one of claims 7 to 9, **characterized in that** step b comprises annealing, at a temperature elevated relative to room temperature, of the photovoltaic absorber layer (5) with alkali metal doping in an oxygen-containing atmosphere, preferably the oxidic passivating layer (8) being generated from the photovoltaic absorber layer and oxygen.

11. Method according to any one of claims 7 to 10, **characterized in that** step b comprises forming an oxide on the front-contact-side surface (6) of the photovoltaic absorber layer (5) with alkali metal doping.

12. Method according to any one of claims 7 to 11, **characterized by** a step for forming a buffer layer (10) on the oxidic passivating layer (8).

## Revendications

1. Structure stratifiée pour une cellule solaire en couche mince comportant
- une couche absorbante photovoltaïque (5), qui est dopée avec au moins un métal alcalin au moins dans une zone adjacente à une surface côté contact frontal (6) de la couche absorbante photovoltaïque, et
- une couche de passivation d'oxyde (8) au niveau de la surface côté contact frontal (6) de la couche absorbante photovoltaïque (5), la couche de passivation d'oxyde étant une couche de protection contre la corrosion pour la couche absorbante photovoltaïque et étant intégrée au niveau la surface côté contact frontal (6) dans la couche absorbante photovoltaïque (5), la couche absorbante photovoltaïque étant transformée au niveau de la surface (6),
- la couche absorbante photovoltaïque (5) présentant Cu(In₁₋ₓGaₓ)(Se_{1-y}Sy)₂, avec 0 ≤ x, y ≤ 1 et la couche de passivation d'oxyde (8) comprenant (In,Ga)₂O₃ et/ou Mₓ(In,Ga)_{y}O_{z} , avec M = K, Rb, Cs et avec 0 < x, y, z ou
- la couche absorbante photovoltaïque (5) présentant CU₂ZnSn(Se₁₋ₓSₓ)₄, avec 0 ≤ x ≤ 1 et la couche de passivation d'oxyde (8) comprenant SnOₓ avec x = 1 à 2.

2. Structure stratifiée selon la revendication 1, **caractérisée en ce que** la zone adjacente à la surface côté contact frontal (6) de la couche absorbante photovoltaïque (5) est dopée de telle manière qu'elle présente une inversion p-n (9).

3. Structure stratifiée selon la revendication 1 ou 2, **caractérisée en ce que** l'au moins un métal alcalin est le rubidium et/ou le césium.

4. Structure stratifiée selon l'une quelconque des revendications 1 à 3, **caractérisée en ce que** la couche de passivation d'oxyde comprend de plus Al₂O₃.

5. Structure stratifiée selon l'une quelconque des revendications 1 à 4, **caractérisée en ce qu'**une épaisseur (D) de la couche de passivation d'oxyde (8) se situe dans la plage de 1 nm à 50 nm.

6. Structure stratifiée selon l'une quelconque des revendications 1 à 5, **caractérisée en ce qu'**une couche tampon (10) est appliquée sur la couche de passivation d'oxyde (8).

7. Procédé de préparation d'une structure stratifiée pour une cellule solaire en couche mince selon l'une quelconque des revendications 1 à 6 comportant les étapes
a. génération d'une couche absorbante photovoltaïque (5), qui est dopée avec au moins un métal alcalin au moins dans une zone adjacente à une surface côté contact frontal (6) de la couche absorbante photovoltaïque, sur un support et
b. génération d'une couche de passivation d'oxyde (8) au niveau de la surface de la couche absorbante photovoltaïque, la couche de passivation d'oxyde étant une couche de protection contre la corrosion pour la couche absorbante photovoltaïque, l'étape b comprenant une intégration de la couche de passivation d'oxyde (8) au niveau de la surface côté contact frontal (6) dans la couche absorbante photovoltaïque (5), la couche absorbante photovoltaïque (5) étant transformée au niveau de la surface (6).

8. Procédé selon la revendication 7, **caractérisé en ce que** l'étape a comprend les sous-étapes suivantes :
ax. génération de la couche absorbante photovoltaïque (5) et
az. dopage de la couche absorbante photovoltaïque au moins dans la zone adjacente à la surface côté contact frontal (6) de la couche absorbante photovoltaïque avec l'au moins un métal alcalin.

9. Procédé selon la revendication 8, **caractérisé par** une étape d'application de l'au moins un métal alcalin sur la surface côté contact frontal (6) de la couche absorbante photovoltaïque (5), l'étape az comprenant une diffusion de l'au moins un métal alcalin au moins dans la zone adjacente à la surface de la couche absorbante photovoltaïque, en particulier sous une atmosphère de Se et/ou une atmosphère de S.

10. Procédé selon l'une quelconque des revendications 7 à 9, **caractérisé en ce que** l'étape b comprend un tempérage à une température élevée par rapport à la température ambiante de la couche absorbante photovoltaïque (5) comportant un dopage par un métal alcalin dans une atmosphère contenant de l'oxygène, en particulier la couche de passivation d'oxyde (8) étant générée à partir de la couche absorbante photovoltaïque et de l'oxygène.

11. Procédé selon l'une quelconque des revendications 7 à 10, **caractérisé en ce que** l'étape b comprend une application d'un oxyde sur la surface côté contact frontal (6) de la couche absorbante photovoltaïque (5) comportant un dopage par un métal alcalin.

12. Procédé selon l'une quelconque des revendications 7 à 11, **caractérisé par** une étape d'application d'une couche tampon (10) sur la couche de passivation d'oxyde (8) .
